# EUROPEAN PATENT APPLICATION

(11) **EP 4 734 097 A1**
(43) Date of publication of application: **29.04.2026**
(21) Application number: 23942107.6
(22) Date of filing: 27.10.2023
(51) Int. Cl.: G09F 9/302, G09F 9/33

(54) **LED DISPLAY SCREEN**

(30) Priority: 21.06.2023 CN 202310743379; 21.06.2023 CN 202321609182 U
(71) Applicant: Shenzhen Infiled Electronics Co., Ltd, Shenzhen, Guangdong 518108 (CN)
(72) Inventor: HAO, Zongchao, Shenzhen, Guangdong 518108 (CN); LIU, Qiuhe, Shenzhen, Guangdong 518108 (CN); HU, Rihao, Shenzhen, Guangdong 518108 (CN); SHU, Peng, Shenzhen, Guangdong 518108 (CN)
(74) Representative: Cabinet Chaillot
(86) International application number: PCT/CN2023/127032
(87) International publication number: WO 2024/259840

(57) **Abstract**

A LED display screen, comprising at least two LED box bodies. A tiling lock catch (100) comprises a handle member (10), a gripper member (20), a hook locking member (40) having a rotating shaft (41), and a connecting member (30) used for being fixed onto one of the LED box bodies; the handle member (10) is provided with a first shaft hole (111) and a second shaft hole (112), the connecting member (30) being rotatably connected in the first shaft hole (111), and the rotating shaft (41) being rotatably connected in the second shaft hole (112); the gripper member (20) is embedded in the handle member (10) and used for limiting the rotation of the rotating shaft (41) relative to the second shaft hole (112); the first shaft hole (111) and the second shaft hole (112) have a first distance (L1) in a first direction and a second distance (L2) in a second direction, the first direction being perpendicular to the second direction; and, when the hook locking member (40) is connected to the other LED box body, the handle member (10) drives the gripper member (20) to rotate around the first shaft hole (111), and a snap-fit structure (212) on the gripper member (20) is snap-fitted to the rotating shaft (41).

## Description

### TECHNICAL FIELD

The present application relates to the field of LED display screens, particularly to an LED display screen.

### BACKGROUND

Existing LED display screens are generally spliced together by multiple display screen units or LED boxes. In order to expand the application range of the product, the LED boxes are spliced together to achieve both planar and three-dimensional splicing.

With the advancement of technology and the expansion of application fields, especially for LED display screens used in the rental field, simple, convenient, fast, stable and reliable operation is required; existing LED boxes require the cooperation among multiple personnel, that is, one assists in aligning two adjacent LED boxes, and one splices the bolts or other splicing structures using splicing tools, which is relatively labor-intensive, and even in relatively small installation spaces, it is impossible to meet the requirement of multiple people standing at the same time, causing inconvenience to the splicing and affecting the splicing efficiency.

### SUMMARY

The present application provides an LED display screen that can be operated by only one person, characterized by a simple structure, convenient operation, high splicing efficiency, reduced labor costs, and good market application value.

The present application provides an LED display screen, comprising a splicing latch and at least two LED boxes, each LED box includes a frame and a light board, the light board is fixed to the frame, and two adjacent frames are fixedly connected by the splicing latch;
The splicing latch includes a handle member, a gripper member, a hook lock with a rotary shaft, and a connector with at least one threaded hole, the handle member is provided with a first shaft hole and a second shaft hole, the connector is rotatably connected in the first shaft hole and fixed to one of the LED boxes through the threaded hole, the rotary shaft is rotatably connected in the second shaft hole, and the gripper member is embedded in the handle member to limit the rotary shaft to rotating relative to the second shaft hole;
The first shaft hole and the second shaft hole have a first distance in a first direction and a second distance in a second direction, and the first direction and the second direction are perpendicular to each other, and when the hook lock is connected to another LED box, the handle member drives the gripper member to rotate around the first shaft hole, and the snap-fit structure on the gripper member is snap-fitted with the rotary shaft, so that the two adjacent LED boxes are connected at the position of the connector.

In the LED display screen of one embodiment of the present application, the handle member comprises a connecting shaft and a handle with an installation cavity, the connector is provided with a connecting hole, the connecting shaft is rotatably connected in the first shaft hole and the connecting hole, and the gripper member is accommodated in the installation cavity and rotates relative to the connector about the axis of the connecting shaft.

In the LED display screen of one embodiment of the present application, the gripper member has a waist shaped hole and a snap-fit structure, the rotary shaft is provided with at least two slot structures, the waist shaped hole extends towards the direction of the snap-fit structure, the connecting shaft runs through the waist shaped hole, and the snap-fit structure is snap-fitted with the slot structure.

In the LED display screen of one embodiment of the present application, the gripper member comprises a limit block and a gripping block, the gripping block is connected to the limit block and elastically connected to the handle, the limit block is provided with an inwardly concave inclined groove at the waist hole, and the snap-fit structure is formed on one corner protrusion of the inwardly concave inclined groove.

In the LED display screen of one embodiment of the present application, the limit block is provided with a through-hole structure, the snap-fit structure is disposed on an outer side of the through-hole structure, and a sharp corner end of the snap-fit structure is located on an extension line of the diameter of the through-hole structure.

In the LED display screen of one embodiment of the present application, the limit block is provided with a claw structure for snap-fitting to the LED box connected to the connector.

In the LED display screen of one embodiment of the present application, the splicing latch further includes a pressure spring, one end of the pressure spring butts against the gripping block, and the other end of the pressure spring butts against the handle.

In the LED display screen of one embodiment of the present application, the handle member further includes a reset spring installed on the handle, and one end of the reset spring butts against the handle, and the other end of the reset spring butts against the rotary shaft.

In the LED display screen of one embodiment of the present application, the handle includes a body and a cover plate, a rotary groove is formed on the body, the cover plate is closed in the rotary groove to form the second shaft hole, and the rotary shaft is vertically connected to a U-shaped hook of the hook lock.

In the LED display screen of one embodiment of the present application, the LED display screen further comprises a fixing block, an installation through-hole is provided on the rotary shaft, and the U-shaped hook of the hook lock is installed in the installation through-hole through the fixing block.

The technical solution provided by the embodiments of the present application may include the following beneficial effects: the present application designs an LED display screen, comprising a handle member, a gripper member, a hook lock, and a connector, the handle member is provided with a first shaft hole and a second shaft hole, the connector is rotatably connected in the first shaft hole, and the hook lock is rotatably installed in the second shaft hole by the rotary shaft, and when two adjacent LED boxes are spliced, the connector is fixed on one of the LED boxes, and the handle member drives the hook lock to connect with the other LED box, so that the two LED boxes can be tightly fixed together under the rotation of the handle member, and the structure is simple, easy to operate, and provides high splicing efficiency, also reducing labor costs and having good market application value.

It should be understood that the above general description and subsequent detailed description are only exemplary and explanatory, and cannot limit the present application.

### BRIEF DESCRIPTION OF THE DRAWINGS

In order to more clearly illustrate the technical solution of the embodiments of the present application, a brief introduction will be given to the accompanying drawings required for the description of the embodiments. Obviously, the accompanying drawings described below are some embodiments of the present application. Those of ordinary skill in the art can obtain other drawings based on these drawings without creative work.
FIG. 1 is a structural diagram of an LED display screen provided in an embodiment of the present application;
FIG. 2 is a structural diagram of the frame in FIG. 1;
FIG. 3 is a structural diagram of the splicing latch in FIG. 1;
FIG. 4 is a schematic diagram of the installation of the splicing latch in FIG. 3;
FIG. 5 is a schematic diagram of the splicing latch provided by an embodiment of the present application in another state;
FIG. 6 is a schematic diagram of the installation of the splicing latch in FIG. 5;
FIG. 7 is a structural diagram of the splicing latch in FIG. 5 at another angle;
FIG. 8 is a structural diagram of the splicing latch in FIG. 5 at another angle;
FIG. 9 is a schematic sectional view of the splicing latch in FIG. 5;
FIG. 10 is a schematic sectional view of the splicing latch in FIG. 5 at another angle;
FIG. 11 is an exploded schematic diagram of the splicing latch in FIG. 5;
FIG. 12 is a structural diagram of the handle in FIG. 11;
FIG. 13 is a structural diagram of the cover plate in FIG. 11;
FIG. 14 is a structural diagram of the rotary shaft in FIG. 11;
FIG. 15 is a structural diagram of the limit block in FIG. 11.

### DETAILED DESCRIPTION OF THE EMBODIMENTS

The technical solutions in the embodiments of the present application will be described clearly and completely in conjunction with the accompanying drawings of the embodiments of the present application. Obviously, the described embodiments are only a part of the embodiments of the present application, rather than all the embodiments. Based on the embodiments of the present application, all other embodiments obtained by those of ordinary skill in the art without creative work shall fall within the protection scope of the present application.

It should be understood that in the description of the present application, the directional or positional relationships indicated by the terms "center", "longitudinal", "transverse", "length", "width", "thickness", "up", "down", "front", "back", "left", "right", "vertical", "horizontal", "top", "bottom", "inside", "outside", "clockwise", "counterclockwise" are based on the directional or positional relationships shown in the accompanying drawings, only for the convenience of describing and simplifying the description of the present application, and do not indicate or imply that the equipment or components referred to must have specific orientations, or must be constructed and operated in specific orientations. Therefore, they cannot be understood as a limitation on the present application. In addition, The terms "first" and "second" are only used for descriptive purposes and cannot be understood as indicating or implying relative importance or implying the number of technical features indicated. Thus, the features limited to "first" and "second" may explicitly or implicitly include one or more of these features. In the description of the present application, unless otherwise specified, the meaning of "a plurality of" refers to two or more.

Some embodiments of the present application will be described in detail below with reference to the accompanying drawings. In non-conflicting situations, the following embodiments and their features can be combined with each other.

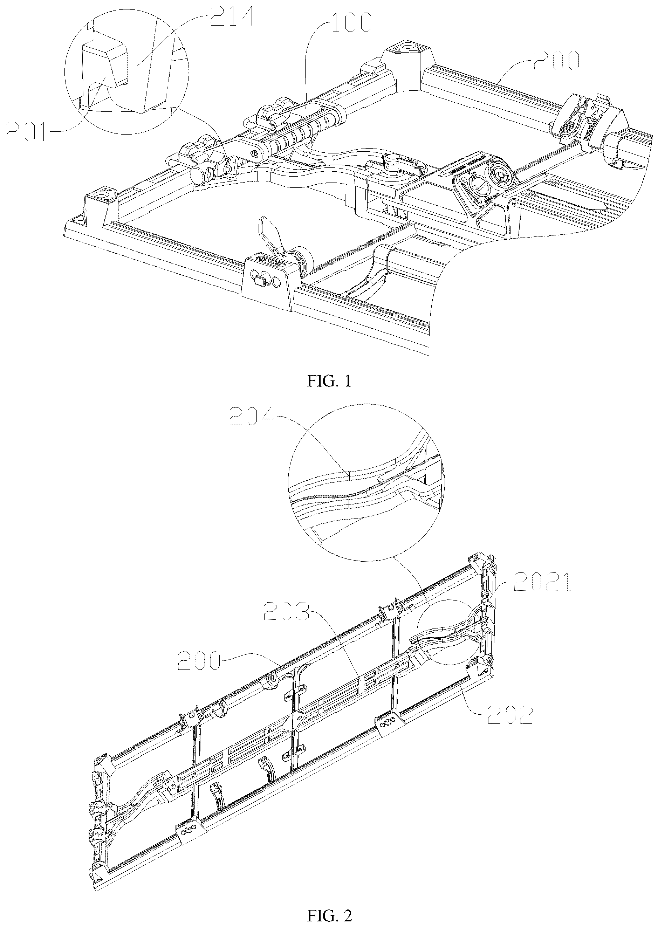

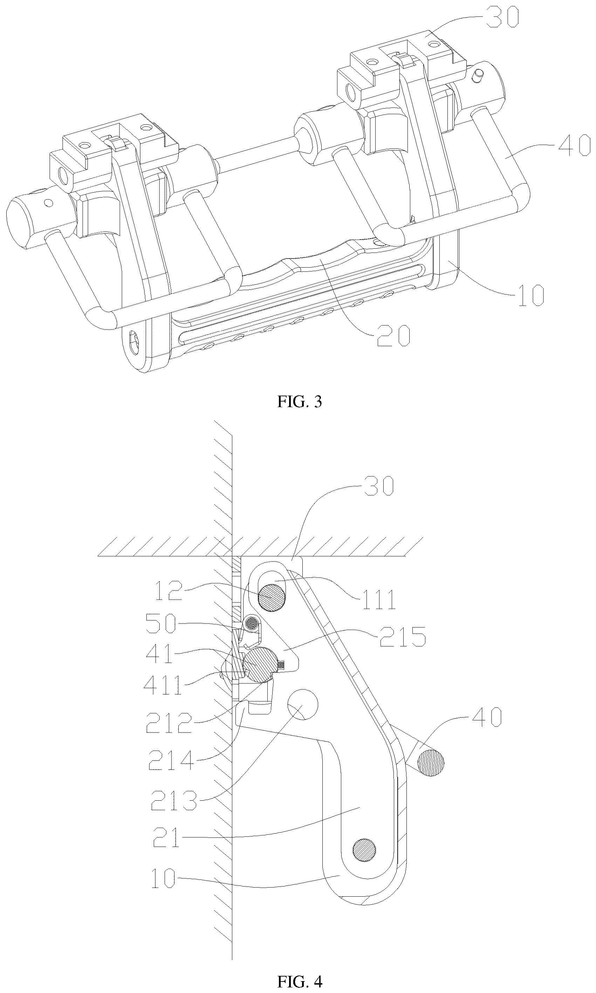

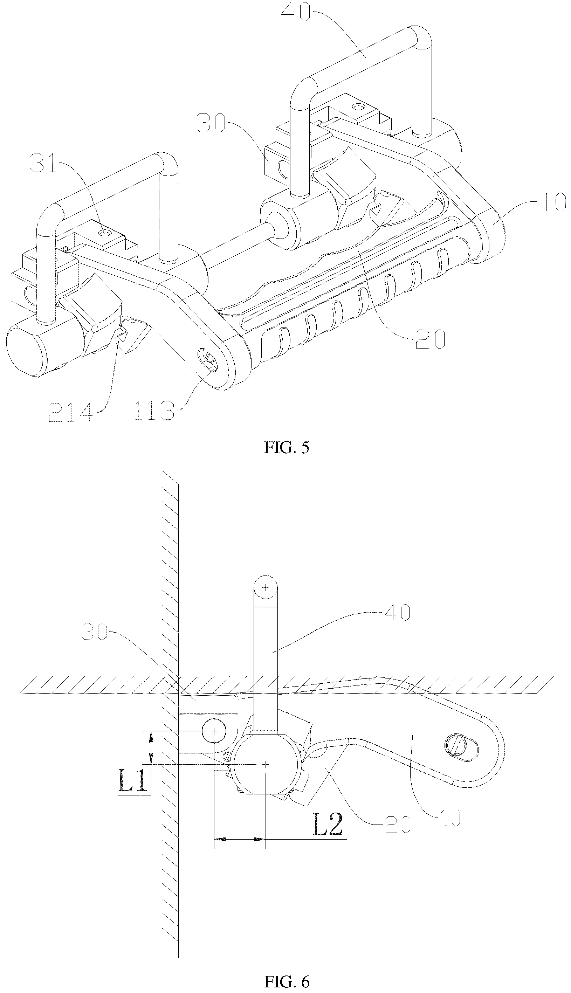

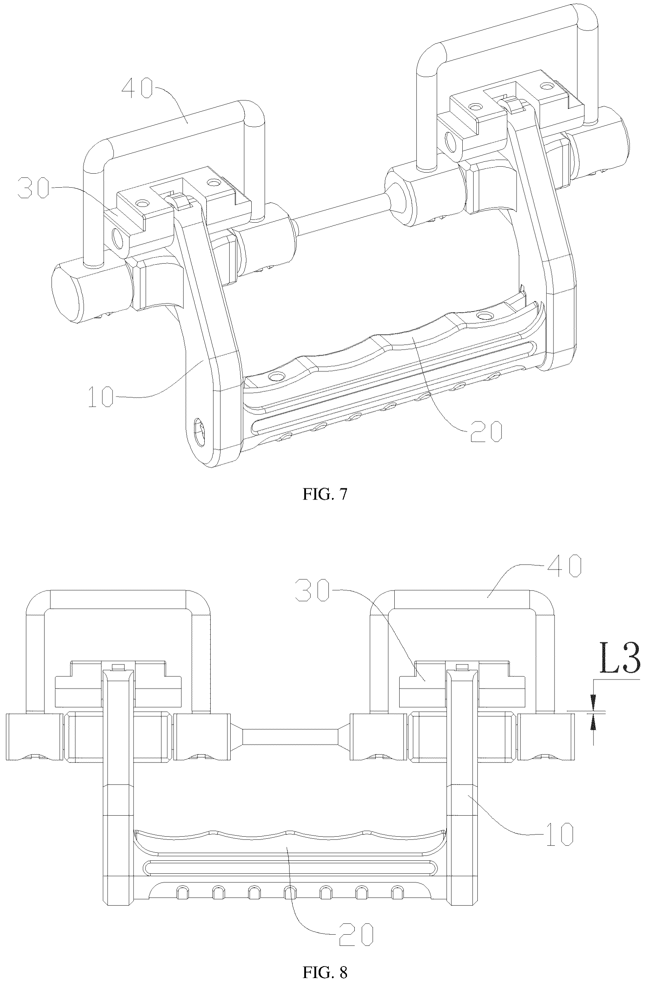

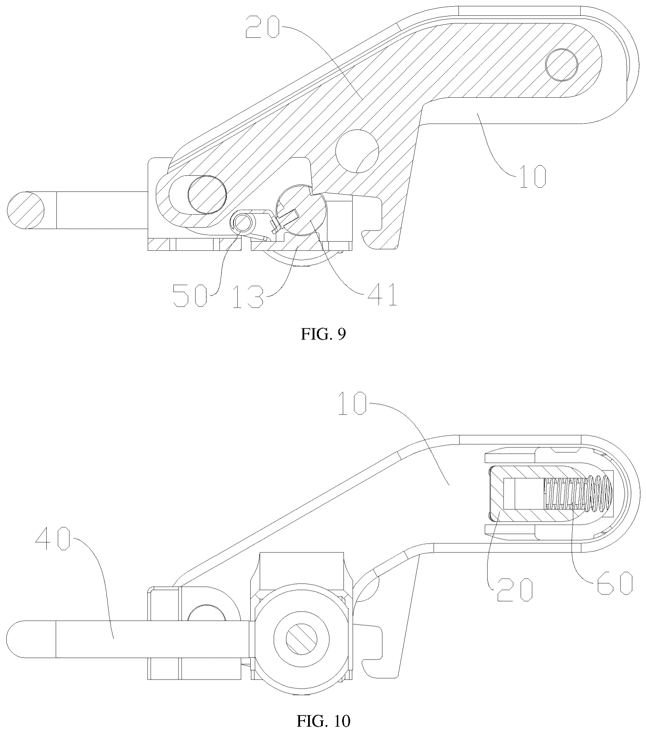

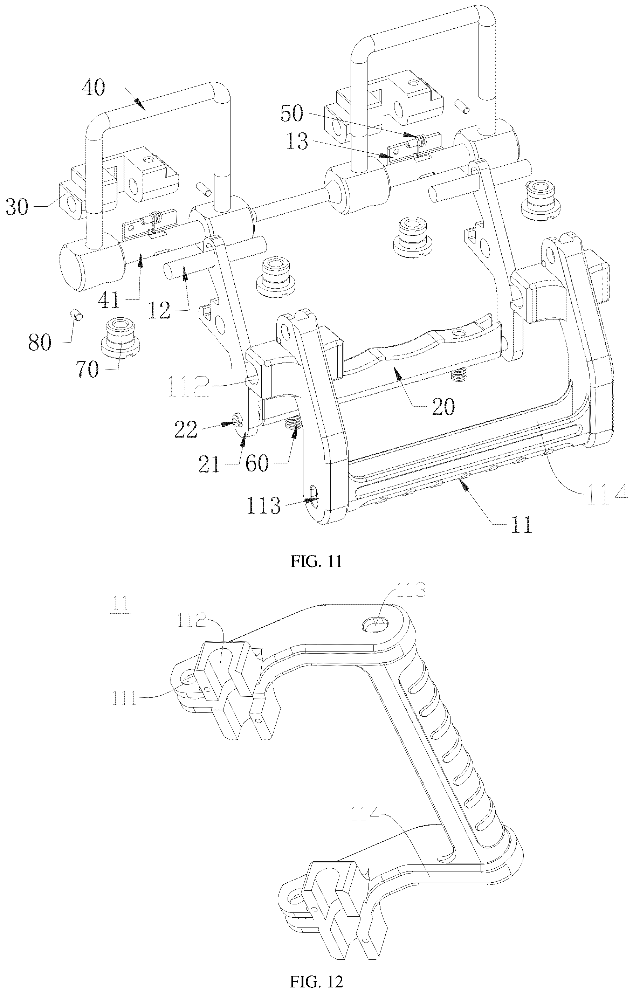

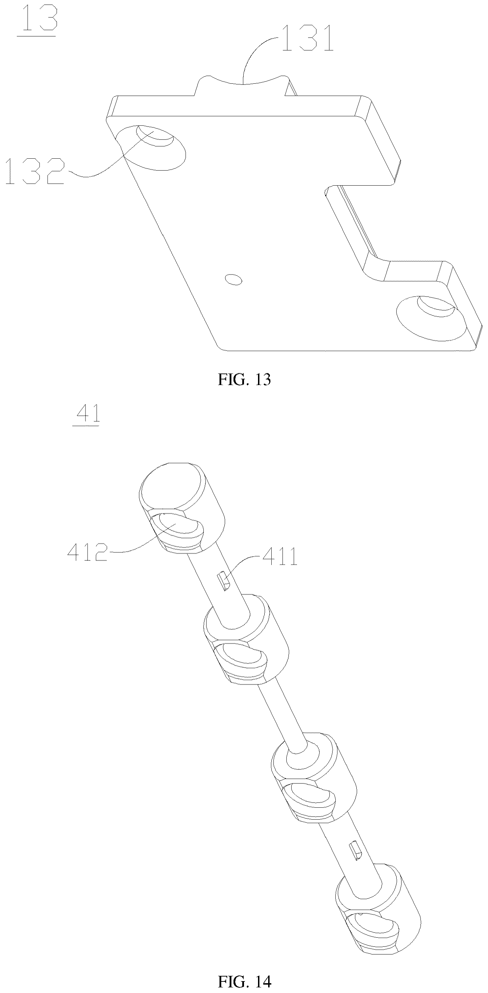

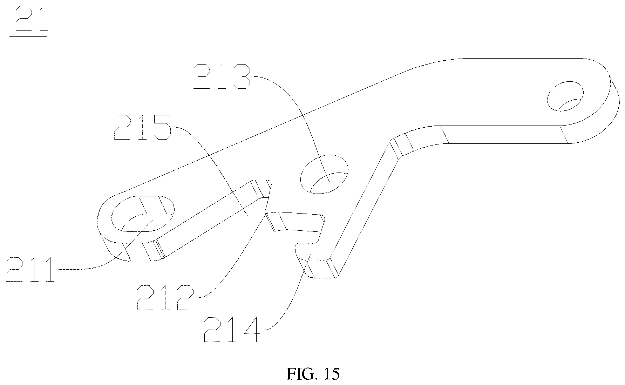

As shown in FIG. 1 to FIG. 15, the present application provides an LED display screen, comprising a splicing latch 100 and at least two LED boxes, each LED box includes a frame 200 and a light board, the light board is fixed to the frame, and two adjacent frames are fixedly connected by the splicing latch to achieve fast splicing of LED display screen, which can be completed by only one person, with a simple and secure structure, easy operation, high splicing efficiency, reduced labor costs, and good market application value.

The splicing latch 100, for example, includes a handle member 10, a gripper member 20, a connector 30 and a hook lock 40, the handle member 10 is provided with a first shaft hole 111 and a second shaft hole 112 spaced apart, and the connector 30 is rotatably connected to the first shaft hole 111 for fixing on at least one of the two LED boxes; the hook lock 40 has a rotary shaft 41 that is rotatably connected in the second shaft hole 112 for connecting with another adjacent LED box. In this embodiment, the gripper member is embedded in the handle member to limit the rotary shaft 41 to rotating relative to the second shaft hole 112, so that two adjacent LED boxes are fixed together through the splicing latch, providing quick splicing and structural fastening.

In an alternative embodiment, the first shaft hole 111 and the second shaft hole 112 have a first distance L1 in the first direction and a second distance L2 in the second direction, and the first direction and the second direction are perpendicular to each other, and when the hook lock 40 is connected to another LED box, the handle member 10 drives the gripper member 20 to rotate around the first shaft hole 111, and the snap-fit structure 212 on the gripper member 20 is snap-fitted with the rotary shaft, so that the two adjacent LED boxes are connected at the position of the connector 30.

Specifically, the hook lock 40 includes a U-shaped hook that is connected to the rotary shaft 41 and can rotate around the axis of the rotary shaft 41. At least one threaded hole 31 is provided on the connector 30, which is used for fixed connection with the frame of the LED box, the U-shaped hook rotates around the axis of the rotary shaft 41 and is sleeved onto the frame of another adjacent LED box, then the rotary shaft 41 and the gripper member 20 are driven by the handle member 10 to rotate around the first shaft hole 111, so that the frames of the two LED boxes can be fastened and spliced together, and the gripper member 20 can limit the rotation angle of the rotary shaft 41, and the U-shaped hook can be stationary relative to the handle member 10 under the restriction of the gripper member 20. The U-shaped hook cannot rotate relative to the handle member 10 to unlock the two adjacent LED boxes until the handle member 10 drives the gripper member 20 to rotate relative to the rotary shaft 41 and release the clamping between the rotary shaft 41 and the gripper member 20.

In an alternative embodiment, the handle member 10 comprises a connecting shaft 12 and a handle with an installation cavity 114, the connector 30 is provided with a connecting hole, the connecting shaft 12 is rotatably connected in the first shaft hole 111 and the connecting hole, and the gripper member 20 is accommodated in the installation cavity 114 and rotates relative to the connector 30 about the axis of the connecting shaft 12, so that the handle member 10 to drive the gripper member 20 and hook lock 40 to rotate around the axis of connecting shaft 12, and then when the handle member 10 and gripper member 20 rotate to a certain angle, the handle member 10 drives the gripper member 20 to rotate around the axis of rotary shaft 41, so that the gripper member 20 can tighten the connecting shaft 12 and also be snap-fitted with the rotary shaft 41 through the snap-fit structure 212, thereby fixing the relative position between the hook lock 40 and the connector 30 and splicing the two adjacent LED boxes together, and the splicing position of the two LED boxes is at the fixed position between the connector 30 and the frame of the LED box.

In an alternative embodiment, the gripper member 20 has a waist shaped hole 211 and a snap-fit structure 212, the rotary shaft 41 is provided with at least two slot structures 411, the waist shaped hole 211 extends towards the direction of the snap-fit structure 212, the connecting shaft 12 runs through the waist shaped hole 211 and the first shaft hole 111, and during the rotation of the gripper member 20 relative to the rotary shaft 41, the snap-fit structure 212 is snap-fitted with the slot structure 411, so that the relative fixation between the rotary shaft 41 and the handle member 10 is realized, or the connector 30, in cooperation with the connecting shaft 12 and waist shaped hole 211, and together with the snap-fit structure 212 in cooperation with the slot structure 411, the relative fixation between the connector 30 and the rotary shaft 41 is realized, that is, the U-shaped hook cannot detach from the other LED box of the two adjacent LED boxes on its own when the handle member 10 is not subject to any external force, while the connector 30 is connected to one of the two adjacent LED boxes through a screw hole, thus enabling a tight connection between the two LED boxes.

In an alternative embodiment, the gripper member 20 comprises a limit block 21 and a gripping block, the gripping block is connected to the limit block 21 and elastically connected to the handle, the limit block 21 is provided with a inwardly concave inclined groove 215 at the waist shaped hole, and the snap-fit structure 212 is formed on one corner protrusion of the inwardly concave inclined groove, characterized by a simple structure and convenient processing.

In an alternative embodiment, the limit block 21 is provided with a through-hole structure 213, the snap-fit structure 212 is disposed on the outer side of the through-hole structure 213, and the sharp corner end of the snap-fit structure 212 is located on an extension line of the diameter of the through-hole structure 213, so that the through-hole structure 213 can provide elastic support for the deformation of the snap-fit structure 212, ensuring that the snap-fit structure 212 can tightly adhere to the outer side of the rotary shaft 41 and can be snap-fitted to the slot structure 411 at the position of the slot structure 411, and when the snap-fit structure 212 disengages from the slot structure 411, the elastic support can be restored, making it less prone to plastic deformation.

In an alternative embodiment, the limit block 21 is provided with a claw structure 214 for snap-fitting to the LED box connected to the connector 30

The LED box, for example, includes a first LED box and a second LED box, and when the splicing latch is fixed on the first LED box through the connector 30, the handle member 10 and gripper member 20 can rotate relative to the connector 30 around the connecting shaft 12, while the U-shaped hook can rotate around the handle member 10 through the rotary shaft 41, and after the U-shaped hook rotates relative to the handle member 10 and is connected to the second LED box, the handle member 10 drives the gripper member 20 and the U-shaped hook to rotate around the connecting shaft 12. Similarly, when the handle member 10 is driving the gripper member 20 to rotate, the U-shaped hook will also rotate relative to the handle member 10 and the gripper member 20, and when the handle member 10 drives the gripper member 20 to rotate to a certain angle, the snap-fit structure 212 is snap-fitted with the slot structure 411 to limit the rotary shaft 41 to rotating relative to the handle member 10, the claw structure 214 is also snap-fitted on the outer frame hook body 201 of the first LED box to ensure that the handle member 10, when without being subject to external force, is stationary relative to the first LED box, and no arbitrary rotation will occur.

In an alternative embodiment, the splicing latch 100 further includes a pressure spring 60, one end of the pressure spring 60 butts against the gripping block, and the other end of the pressure spring 60 butts against the handle, making the engagement between the snap-fit structure 212 and the slot structure 411 more stable, meanwhile, it is necessary to press the gripping block, that is, the limit block 21 needs to move along the extension direction of the waist shaped hole 211 through the connecting shaft 12 to release the engagement between the snap-fit structure 212 and the slot structure 411, so that the rotary shaft 41 can rotate around the handle member 10 again to release the splicing between the two LED boxes. The above technical solution allows to eliminate the fit clearance between the two LED boxes, providing a more tight locking and highly accurate splicing between the two LED boxes.

The gripping block, for example, is provided with a pressure spring installation groove, and the pressure spring installation groove extends from the bottom towards the groove with a spring connection column. One end of the pressure spring 60 is installed on the spring connection column, and the other end of the pressure spring 60 butts against the bottom of installation cavity 114, so that the gripping block can retract into the installation cavity 114 when pressed, and extend out of the installation cavity 114 when not pressed.

In an alternative embodiment, the gripping block and limit block 21 are connected by a first set screw 22, a screw hole is provided on the handle, and the screw hole has a first movable space along the extension direction of the waist shaped hole 211, so that the gripping block can move along the extension direction of the screw hole under the action of the pressure spring 60, that is, the gripping block is located at the bottom of the screw hole when the gripping block is pressed, and is located at the top of the screw hole after the gripping block is released, thereby achieving the engagement or disengagement between the snap-fit structure 212 and the slot structure 411.

In an alternative embodiment, the splicing latch 100 further includes a reset spring 50 installed on the handle, and one end of the reset spring 50 butts against the handle, and the other end of the reset spring 50 butts against the rotary shaft 41, used to drive the rotary shaft 41 to rebound and reset, in further resetting the U-shaped hook.

In an alternative embodiment, the handle includes a body 11 and a cover plate 13, a rotary groove is formed on the body 11, the cover plate 13 is closed in the rotary groove to form the second shaft hole 112, and the rotary shaft 41 is vertically connected to the U-shaped hook of the hook lock 40.

The cover plate 13, for example, has an arc-shaped protrusion 131 and a cover plate installation hole 132, the cover plate 13 is installed on the body 11 through the cover plate installation hole 132, the rotary shaft 41 is rotatably installed in the second shaft hole 112 formed by the arc-shaped protrusion 131 and the rotary groove. The cover plate 13 has a reset spring fixing hole, and the rotary shaft 41 is connected to a reset spring connecting column, so that one end of the reset spring 50 can be connected to the reset spring fixing hole, and the other end of the reset spring 50 can be connected to the connecting column hole on the reset spring connecting column, and this installation method enables more convenient installation of the reset spring 50 compared to connecting the reset spring 50 to the body 11, that is, the reset spring 50 is sleeved on the spring column connected to the body 11, and then the two ends of the reset spring 50 are connected to the rotary shaft 41 and the cover plate 13, respectively, and the cover plate 13 is then closed in the rotary groove.

In an alternative embodiment, the LED display screen further comprises a fixing block 70 and a second set screw 80, an installation through-hole 412 is provided on the rotary shaft 41, the U-shaped hook is installed in the installation through-hole 412 through the fixing block 70, the second set screw 80 is locked from the side of the rotary shaft 41 for fastening the U-shaped hook, and the connection distance L3 of the U-shaped hook relative to the rotary shaft 41 can be adjusted so that the U-shaped hook can be used to splice LED box of different sizes and specifications.

In an alternative embodiment, the frame 200 includes an outer frame body 202 and an installation plate 203 that is used for installing the central control box and is disposed on the inner side of the outer frame body, and at least two arc-shaped ribs 204 are connected between the outer frame body 202 and the two ends of the installation plate 203, and the spacing between the two arc-shaped ribs 204 gradually widens from the installation plate 203 to the outer frame body 202, in order to enhance the uniform force distribution between two adjacent frames 200 during splicing.

A locking installation area, for example, is formed at the position of the outer frame body 202 and the arc-shaped rib 204, and the outer frame body 202 is provided with a connecting protrusion 2021 on the locking installation area, the connector 30 is connected to the connecting protrusion 2021 through a screw that runs through the threaded hole 31, the U-shaped hook rotates from one side of the connecting protrusion 2021 to the other side of the connecting protrusion 2021, tightly connecting the connecting protrusions 2021 of two adjacent LED boxes together, thereby splicing the two adjacent LED boxes; the handle member 10, when being rotated, can drive the gripper member 20 to rotate relative to the rotation shaft 41 and release the engagement between the rotation shaft 41 and the gripper member 20, so that the U-shaped hook can rotate relative to the connecting protrusion 2021, that is, rotate from the other side of the connecting protrusion 2021 to the side of the connecting protrusion 2021, separating the two adjacent LED boxes.

In an alternative embodiment, three arc-shaped ribs 204 are provided, one of which is connected to the middle of the outer frame body 202 and the installation plate 203, and the other two arc-shaped ribs 204 are disposed symmetrically with the arc-shaped ribs 204 connected to the middle of the installation plate 203, and one end of the two symmetrically disposed arc-shaped ribs 204 close to the outer frame body 202 extends towards the direction away from the middle arc-shaped rib and is connected in an arc shape to the outer frame body 202, so that the outer frame body 202 can be connected to the arc-shaped rib 204 as a whole.

Specifically, the three arc-shaped ribs 204 are connected together by connecting ribs to form a structure similar to a fish tail, which can enhance the uniform force distribution between the frames 200 during splicing, and also reduce the weight of the frames 200 through scientific and reasonable design, providing a lightweight design for LED display screens.

In an alternative embodiment, the end of the three arc-shaped ribs 204 close to the outer frame body 202 is lower in height than the other end of the three arc-shaped ribs 204 close to the installation plate 203.

The two ends of the installation plate 203, for example, have connecting protrusions, and the maximum distance between the highest point of the connecting protrusion and the lowest point of the installation plate 203 can be the height of the two ends of the central control box, so that the two ends of the central control box are flush with the connecting protrusions after being installed on the installation plate 203.

In an alternative embodiment, the installation plate 203 is provided with a hollow structure to further reduce the weight of the frame 200 and ensure the lightweight design of the LED display screen, so that the LED display screen of such structure has the advantages of overall thin thickness and small volume.

In the description of the present application, it should be noted that unless otherwise implicitly specified and limited, the terms "installation", "provided with", "sleeved/connected with", "connection", etc. should be broadly understood and, for example, "connection" can be a fixed connection, a detachable connection, or an integral connection; and can be a mechanical connection or an electrical connection; can be direct connection, indirect connection through an intermediate medium, or a connection within two components or an interaction relationship between two components. The person having ordinary skill in the art can understand the specific meanings of the above terms in the present application in specific situations.

In the present application, unless otherwise specified and limited, the first feature "above" or "below" the second feature may include direct contact between the first and second features, or may include contact between the first and second features through another feature instead of direct contact. Moreover, the first feature being 'above', 'over', and 'on top of' the second feature includes the first feature being directly above and diagonally above the second feature, or simply indicating that the first feature is horizontally higher than the second feature. The first feature being "below", "beneath", and "under" include the first feature being directly below and diagonally below the second feature, or simply indicating that the first feature has a lower horizontal height than the second feature.

The above disclosure provides many different implementation methods or examples to achieve different structures of the present application. In order to simplify the disclosure of the present application, the components and settings of specific examples are described in the preceding text. Of course, they are only examples and are not intended to limit the scope of the present application. In addition, the present application may repeat reference numbers and/or letters in different examples for the purpose of simplification and clarity, and does not in itself indicate the relationship between the various embodiments and/or settings discussed. In addition, the present application provides examples of various specific processes and materials, but those of ordinary skill in the art may be aware of the application of other processes and/or the use of other materials.

In the description of the present specification, the reference to the terms "one embodiment", "some embodiments", "illustrative embodiments", "examples", "specific examples", or "some examples" is intended to refer to the specific features and structures described in conjunction with this embodiment or example. The materials or features are included in at least one embodiment or example of the present application. In the specification, the illustrative expressions of the above terms may not necessarily refer to the same implementation or examples. Moreover, the specific features, structures, materials, or characteristics described can be combined in any one or more embodiments or examples in an appropriate manner.

### Industrial applicability

An LED display screen, wherein the LED display screen comprises at least two LED boxes, the splicing latch includes a handle member, a gripper member, a hook lock with a rotary shaft, and a connector for fixing to one of the LED boxes, the handle member is provided with a first shaft hole and a second shaft hole, the connector is rotatably connected in the first shaft hole, the rotary shaft is rotatably connected in the second shaft hole, and the gripper member is embedded in the handle to limit the rotary shaft to rotating relative to the second shaft hole; the first shaft hole and the second shaft hole have a first distance in the first direction and a second distance in the second direction, and the first direction and the second direction are perpendicular to each other, and when the hook lock is connected to another LED box, the handle member drives the gripper member to rotate around the first shaft hole, and the snap-fit structure on the gripper member is snap-fitted with the rotary shaft.

The present application designs an LED display screen, comprising a handle member, a gripper member, a hook lock, and a connector, the handle member is provided with a first shaft hole and a second shaft hole, the connector is rotatably connected in the first shaft hole, and the hook lock is rotatably installed in the second shaft hole through the rotary shaft, and when two adjacent LED boxes are spliced, the connector is fixed on one of the LED boxes, and the handle member drives the hook lock to connect with the other LED box, so that the two LED boxes can be tightly fixed together under the rotation of the handle member, and the structure is simple, easy to operate, and provides high splicing efficiency, also reducing labor costs and having good market application value.

## Claims

1. A LED display screen, comprising a splicing latch and at least two LED boxes, each LED box includes a frame and a light board, the light board is fixed to the frame, and two adjacent frames are fixedly connected by the splicing latch;
the splicing latch includes a handle member, a gripper member, a hook lock with a rotary shaft, and a connector with at least one threaded hole, the handle member is provided with a first shaft hole and a second shaft hole, the connector is rotatably connected in the first shaft hole and fixed to one of the LED boxes through the threaded hole, the rotary shaft is rotatably connected in the second shaft hole, and the gripper member is embedded in the handle member to limit the rotary shaft to rotating relative to the second shaft hole;
the first shaft hole and the second shaft hole have a first distance in a first direction and a second distance in a second direction, and the first direction and the second direction are perpendicular to each other, and when the hook lock is connected to another LED box, the handle member drives the gripper member to rotate around the first shaft hole, and the snap-fit structure on the gripper member is snap-fitted with the rotary shaft, so that the two adjacent LED boxes are connected at the position of the connector.

2. The LED display screen according to claim 1, **characterized in that** the handle member comprises a connecting shaft and a handle with an installation cavity, the connector is provided with a connecting hole, the connecting shaft is rotatably connected in the first shaft hole and the connecting hole, and the gripper member is accommodated in the installation cavity and rotates relative to the connector about the axis of the connecting shaft.

3. The LED display screen according to claim 2, **characterized in that** the gripper member has a waist shaped hole and a snap-fit structure, the rotary shaft is provided with at least two slot structures, the waist shaped hole extends towards the direction of the snap-fit structure, the connecting shaft runs through the waist shaped hole, and the snap-fit structure is snap-fitted with the slot structure.

4. The LED display screen according to claim 3, **characterized in that** the gripper member comprises a limit block and a gripping block, the gripping block is connected to the limit block and elastically connected to the handle, the limit block is provided with an inwardly concave inclined groove at the waist hole, and the snap-fit structure is formed on one corner protrusion of the inwardly concave inclined groove.

5. The LED display screen according to claim 4, **characterized in that** the limit block is provided with a through-hole structure, the snap-fit structure is disposed on an outer side of the through-hole structure, and a sharp corner end of the snap-fit structure is located on an extension line of the diameter of the through-hole structure.

6. The LED display screen according to claim 4, **characterized in that** the limit block is provided with a claw structure for snap-fitting to the LED box connected to the connector.

7. The LED display screen according to claim 4, **characterized in that** the splicing latch further comprises a pressure spring, one end of the pressure spring butts against the gripping block, and the other end of the pressure spring butts against the handle.

8. The LED display screen according to claim 2, **characterized in that** the handle member further comprises a reset spring installed on the handle, and one end of the reset spring butts against the handle, and the other end of the reset spring butts against the rotary shaft.

9. The LED display screen according to claim 1, **characterized in that** the handle comprises a body and a cover plate, a rotary groove is formed on the body, the cover plate is closed in the rotary groove to form the second shaft hole, and the rotary shaft is vertically connected to a U-shaped hook of the hook lock.

10. The LED display screen according to claim 1, further comprising a fixing block, **characterized in that** an installation through-hole is provided on the rotary shaft, and the U-shaped hook of the hook lock is installed in the installation through-hole through the fixing block.

11. The LED display screen according to claim 1, **characterized in that** the frame comprises an outer frame body and an installation plate that is used for installing the central control box and is disposed on an inner side of the outer frame body, and at least two arc-shaped ribs are connected between the outer frame body and the two ends of the installation plate, and a spacing between the two arc-shaped ribs gradually widens from the installation plate to the outer frame body.

12. The LED display screen according to claim 11, **characterized in that** three arc-shaped ribs are provided, one of which is connected to the middle of the outer frame body and the installation plate, and the other two arc-shaped ribs are disposed symmetrically with the arc-shaped rib connected to the middle of the installation plate, and one end of the two symmetrically disposed arc-shaped ribs close to the outer frame body extends towards the direction away from the middle arc-shaped rib and is connected in an arc shape to the outer frame body.

13. The LED display screen according to claim 12, **characterized in that** the end of the three arc-shaped ribs close to the outer frame body is lower in height than the other end of the three arc-shaped ribs close to the installation plate; alternatively, the installation plate is provided with a hollow structure.
